(19) **Europäisches Patentamt / European Patent Office / Office européen des brevets**

(11) **EP 1 673 868 B1**

(12) **FASCICULE DE BREVET EUROPEEN**

(45) Date de publication et mention de la délivrance du brevet:
**11.05.2011 Bulletin 2011/19**

(21) Numéro de dépôt: **04791210.0**

(22) Date de dépôt: **13.10.2004**

(51) Int Cl.:
***H03M 1/06*** (2006.01)

(86) Numéro de dépôt international:
**PCT/EP2004/052518**

(87) Numéro de publication internationale:
**WO 2005/036754 (21.04.2005 Gazette 2005/16)**

(54) **CIRCUIT DE COMPARAISON POUR CONVERTISSEUR ANALOGIQUE-NUMERIQUE**

VERGLEICHSSCHALTUNG FÜR EINEN ANALOG/DIGITAL-UMSETZER

COMPARISON CIRCUIT FOR ANALOG/DIGITAL CONVERTER

(84) Etats contractants désignés:
**DE FR GB NL**

(30) Priorité: **17.10.2003 FR 0312182**

(43) Date de publication de la demande:
**28.06.2006 Bulletin 2006/26**

(73) Titulaire: **E2V Semiconductors**
**38120 Saint Egreve (FR)**

(72) Inventeur: **MORISSON, Richard,**
**THALES Intellectual Property**
**94117 ARCUEIL (FR)**

(74) Mandataire: **Collet, Alain**
**Marks & Clerk France**
**Conseils en Propriété Industrielle**
**Immeuble " Visium "**
**22, avenue Aristide Briand**
**94117 Arcueil Cedex (FR)**

(56) Documents cités:
**US-B1- 6 169 510**

- **CHOI M ET AL: "A 6b 1.3GSample/s A/D converter in 0.35/spl mu/m CMOS" IEEE JOURNAL OF SOLID STATE CIRCUITS, décembre 2001 (2001-12), pages 1847-1858, XP002316175**
- **LEUCIUC A ET AL: "Active Spatial Filtering for A/D Converters" IEEE INTERNATIONAL SYMPOSIUM ON CIRCUITS AND SYSTEMS, vol. 2, 26 mai 2002 (2002-05-26), - 29 mai 2002 (2002-05-29) pages II 392-II 395, XP002284282**

**Description**

L'invention se rapporte à un circuit de comparaison pour un convertisseur analogique-numérique. Le circuit de comparaison comporte un réseau de comparateurs comparant chacun une tension analogique à convertir avec une tension de référence. La tension analogique à convertir est généralement issue d'un échantilloneur-bloqueur permettant à l'ensemble des comparateurs du réseau de recevoir la même tension analogique au moment où ils effectuent la comparaison avec la tension de référence.

Les tensions de référence que reçoivent les comparateurs sont réparties sur une plage dans laquelle la tension analogique peut évoluer. La répartition est généralement uniforme sur la plage et elle est par exemple obtenue au moyen d'un réseau de résistances, toutes de même valeur et raccordées en série entre les bornes d'une source de tension d'alimentation du comparateur. Il y a sensiblement autant de résistances que de comparateurs. Les tensions de référence sont alors prélevées aux différents points de jonction des résistances entre elles.

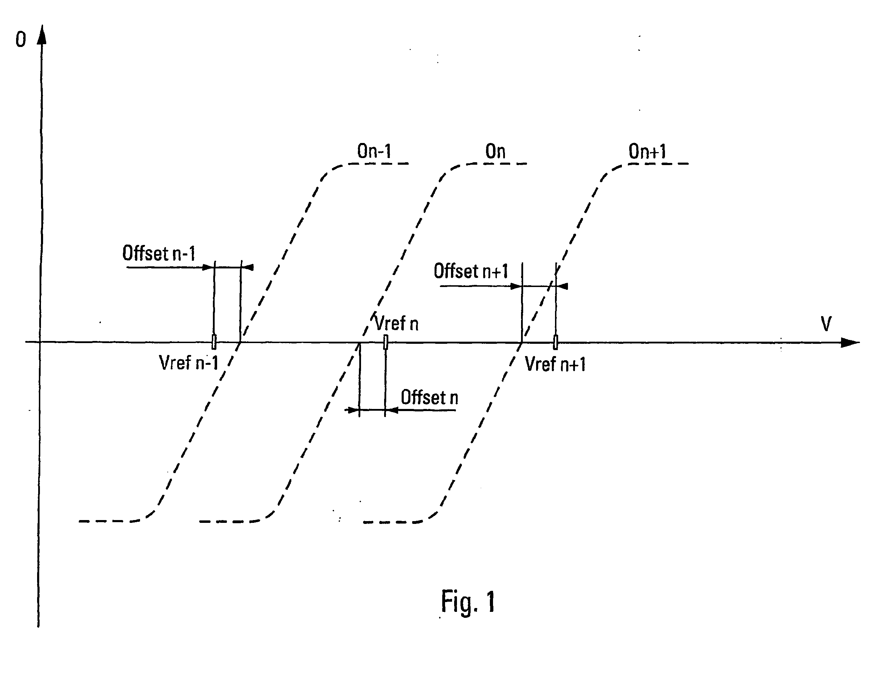

Chaque comparateur comporte deux sorties, l'une directe et l'autre inverse. Les tensions présentes sur ses sorties sont fonction de la différence de potentiel entre la tension analogique et la tension de référence reçue par le comparateur concerné. La figure 1 représente trois courbes montrant l'évolution de la tension présente sur la sortie directe On-1, On et On+1 en fonction de la tension analogique V, pour trois comparateurs C de rang n-1, n et n+1 dans le réseau de comparateurs. Ces trois comparateurs reçoivent respectivement des tensions de références Vref n-1, Vref n et Vref n+1. Les comparateurs reçoivent des tensions de référence voisines dans leur répartition sur la plage.

Pour un comparateur donné, par exemple le comparateur de rang n, si sa réponse était parfaite, la tension On présente sur sa sortie directe devrait être nulle lorsque la tension analogique V est égale à la tension de référence Vn. Or, la réponse des comparateurs est imparfaite et on constate un écart de tension, dit tension d'offset, entre la tension de référence Vref n et la tension analogique V entraînant une tension On nulle sur la sortie directe du comparateur de rang n. Dans la pratique on constate que chaque comparateur C a sa propre tension d'offset indépendante de celle des autres comparateurs. Sur la figure 1, le comparateur C de rang n-1 a une tension d'offset Offset n-1, le comparateur C de rang n a une tension d'offset Offset n et le comparateur C de rang n+1 a une tension d'offset Offset n+1. Les tensions d'offset peuvent être négatives ou positives. Leurs valeurs sont aléatoirement réparties pour les différents comparateurs d'un convertisseur analogique-numérique. Ces tensions d'offset détériorent la précision du convertisseur et on constate qu'elles tendent à augmenter lorsqu'on réduit la taille du composant électronique sur lequel est réalisé le convertisseur.

Par ailleurs, la résolution LSB d'un convertisseur analogique numérique peut s'exprimer par l'écart de la tension analogique modifiant la valeur d'un bit de poids faible en sortie du convertisseur. La résolution LSB s'exprime de la façon suivante :

$$LSB = \frac{Vpic/pic}{2^n}$$

où Vpic/pic représente l'amplitude maximum de la tension analogique que peut convertir le convertisseur, et où n est le nombre de comparateurs dans le réseau. Si la résolution LSB est inférieure à trois fois la tension d'offset, on a une perte de linéarité du convertisseur et le bit de poids faible n'est plus significatif.

"A 6b 1.3GSamplels A/D converter in 0.35/spl mu/m CMOS", CHOI M ET AL, décrit un convertisseur analogique numérique où l'effet des tensions d'offset est réduit à travers l'utilisation d'amplificateurs dans des réseaux de résistances connectés aux entrées de comparateurs.

"A 12-b, 60-MSamples/s Cascaded Folding and Interpolating ADC", VORENKAMP PIETER ET AL, décrit un convertisseur analogique numérique où l'effet des tensions d'offset est réduit à travers l'utilisation d'amplificateurs dans des réseaux de résistances. Des suiveurs de tension son connectés entre un premier réseau de résistances, lui même connecté à la sortie de comparateurs, et un réseau d'interpolation.

L'invention a pour but de réduire les effets de ces tensions d'offset en les moyennant sur des convertisseurs voisins. Cette réduction permet d'améliorer la résolution du convertisseur.

A cet effet, l'invention a pour objet, un circuit de comparaison pour un convertisseur analogique-numérique comportant un réseau de comparateurs comparant chacun une tension analogique à convertir avec une tension de référence, les tensions de référence étant réparties sur une plage dans laquelle la tension analogique peut évoluer, chaque comparateur comprenant une sortie directe et une sortie inverse, caractérisé en ce que chaque sortie, directe ou inverse, est raccordée à l'entrée d'un suiveur de tension, les sorties de chaque suiveur de tension étant reliées soit à des entrées d'un premier réseau de résistances délivrant à ses sorties, des tensions moyennes de celles présentes sur des sorties directes de comparateurs recevant des tensions de référence voisines dans leur répartition sur la plage, soit à des entrées d'un second réseau de résistances délivrant à ses sorties, des tensions moyennes de celles présentes sur des sorties inverses de comparateurs recevant des tensions de référence voisines dans leur répartition sur la plage.

L'invention sera mieux comprise et d'autres avantages apparaîtront à la lecture de la description détaillée d'un mode de réalisation donné à titre d'exemple et illustré par le dessin joint dans lequel

la figure 1 représente plusieurs courbes montrant l'évolution de la tension présente sur les sorties directes de comparateurs en fonction de la tension analogique V qui lui est appliquée ; cette figure a déjà été commentée plus haut ;
- la figure 2 représente un circuit de comparaison comportant plusieurs réseaux de résistances permettant de réaliser le moyennage de tensions de sorties directes de plusieurs comparateurs voisins.

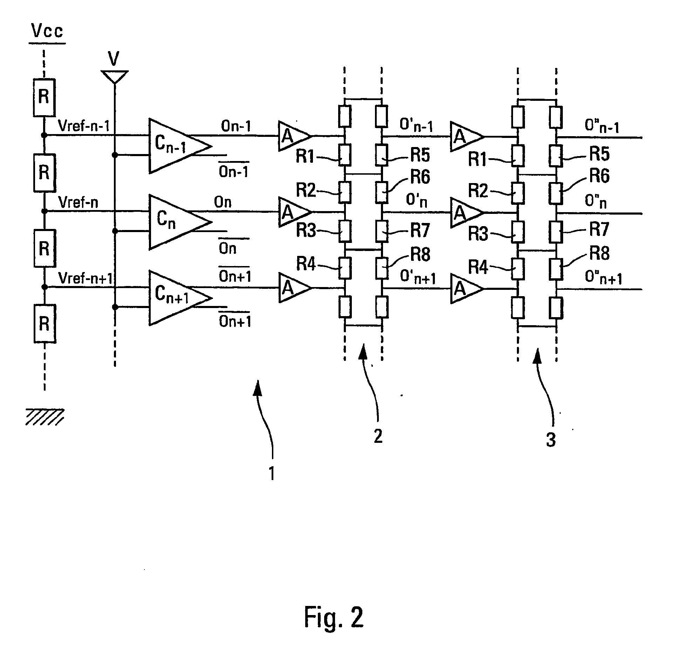

La figure 2 représente un circuit de comparaison 1 comportant un réseau de comparateurs comparant chacun une tension analogique V à convertir avec une tension de référence. Sur la figure 2, trois comparateurs Cn-1, Cn et Cn+1 ont été représentés, n représentant leur rang dans le réseau de comparateurs. Chaque comparateur comporte deux entrées et la tension analogique V est présente sur l'une de ces entrées. L'autre entrée reçoit une tension de référence propre à chaque comparateur C. Les trois comparateurs Cn-1, Cn et Cn+1 reçoivent respectivement des tensions de références Vref n-1, Vref n et Vref n+1 obtenues au moyen d'un réseau de résistances R, toutes raccordées en série entre les bornes d'une source de tension d'alimentation Vcc du comparateur. Chaque comparateur Cn-1, Cn ou Cn+1 comporte deux sorties, l'une directe, respectivement On-1, On ou On+1, et l'autre inverse respectivement $\overline{On-1}$, $\overline{On}$ ou $\overline{On+1}$. Les tensions présentes sur ses sorties sont fonction de la différence de potentiel entre la tension analogique V et la tension de référence Vref n-1, Vref n ou Vref n+1 reçue par le comparateur C concerné. Les tensions présentes sur les sorties des différents comparateurs C évoluent, par exemple, comme représenté sur la figure 1. Pour un comparateur C donné, la tension présente sur sa sortie inverse $\overline{O}$ est égale à la tension symétrique de la tension présente sur sa sortie directe $\overline{O}$ par rapport à une tension moyenne qu'il délivre.

Chaque sortie, directe On-1, On ou On+1 ou inverse $\overline{On-1}$, $\overline{On}$ ou $\overline{On+1}$, est raccordée à l'entrée d'un suiveur de tension A. Chaque suiveur de tension A délivre une tension égale à la tension présente sur la sortie du comparateur à laquelle il est raccordé et a une impédance de sotie très faible.

Les sorties de chaque suiveur de tension A sont reliées soit à une entrée d'un premier réseau 2 de résistances délivrant à ses sorties O'n-1, O'n et O'n+1, des tensions moyennes de celles présentes sur les sorties directes des comparateurs Cn-1, Cn et Cn+1, soit à une entrée d'un second réseau de résistances délivrant à ses sorties $\overline{O'n-1}$, $\overline{O'n}$ et $\overline{O'n+1}$, des tensions moyennes de celles présentes sur les sorties inverses des comparateurs Cn-1, Cn et Cn+1. Pour ne pas surcharger la figure 2 seul le premier réseau 2 de résistances a été représenté. Avantageusement les deux réseaux de résistances ont la même structure.

Avantageusement, chaque réseau de résistances comporte un premier ensemble en série de deux paires identiques de deux résistances identiques en série, R1, R2 d'une part, R3, R4 d'autre part, et un deuxième ensemble en série de deux paires identiques de deux résistances identiques en série R5, R6 d'une part, R7, R8 d'autre part. Les entrées du réseau de résistances sont constituées par les extrémités et le point milieu du premier ensemble en série, et les sorties du réseau de résistances sont constituées par les extrémités et le point milieu du deuxième ensemble en série, le point milieu de la première paire et de la deuxième paire de résistances du premier ensemble sont reliés respectivement au point milieu de la première paire et de la deuxième paire du deuxième ensemble. Cette structure de réseau de résistances est répétée pour pouvoir se raccorder aux sorties de tous les comparateurs C et fournir ainsi autant de sorties O' du réseau de résistances que de sorties O des comparateurs C.

La fonction de transfert de la sortie O'n du premier réseau 2 peut alors s'exprimer de la façon suivante :

$$O'n = \frac{\dfrac{On+On+1}{2} + \dfrac{On+On-1}{2}}{2}$$

Les deux premiers réseaux de résistances permettent de réduire l'erreur statistique due aux différentes tensions d'offset des comparateurs. Plus précisément, on peut déterminer l'écart type σ des tensions d'offset dé l'ensemble des comparateurs C du réseau. On peut, à l'aide de la fonction de transfert du premier réseau de résistance déterminer un écart type équivalent σ' des comparateurs vu des sorties du premier réseau 2 de résistances. L'écart type équivalent σ' peut s'exprimer de la façon suivante :

$$\sigma' = \sigma\sqrt{\frac{3}{8}} \approx 0{,}6\sigma$$

Cette réduction de l'effet de la tension d'offset des comparateurs permet pratiquement d'améliorer la résolution d'un bit de poids faible.

La combinaison des suiveurs de tension A avec le réseau de résistances permet de ne pas perdre de gain en sortie de réseau de résistances par rapport à la sortie du réseau de comparateurs. En l'absence de suiveur de tension A, la réduction de l'effet de la tension d'offset des comparateurs serait plus faible.

Avantageusement les sorties O'n-1, O'n et O'n+1 du premier réseau 2 de résistances sont reliées, par l'intermédiaire de suiveurs de tension A, à des entrées d'un troisième réseau 3 de résistances délivrant à ses sorties O"n-1, O"n et O"n+1, des tensions moyennes de celles présentes sur des entrées voisines du troisième réseau de résistances. De même, les sorties $\overline{O'n-1}$, $\overline{O'n}$ et $\overline{O'n+1}$ du second réseau de résistances sont reliées, par l'intermédiaire de suiveurs de tension A, à des entrées d'un quatrième réseau de résistances délivrant à ses sorties $\overline{O''n-1}$, O"n et $\overline{O''n+1}$, des tensions moyennes de celles présentes sur des entrées voisines du quatrième réseau de résistances. Comme précédemment, pour ne pas surcharger la figure 2, le quatrième réseau de résistances n'est pas représenté. Avantageusement, les quatre réseaux de résistances ont la même structure. La fonction de transfert de la sortie O"n du second réseau 3 de résistances peut s'exprimer de la façon suivante :

$$O''n = \cfrac{\cfrac{O'n + O'n+1}{2} + \cfrac{O'n + O'n-1}{2}}{2}$$

Comme précédemment, un écart type équivalent σ" peut s'exprimer de la façon suivante :

$$\sigma'' = \sigma'\sqrt{\frac{3}{8}} = \sigma\sqrt{\frac{3}{8}}x\sqrt{\frac{3}{8}} \approx 0{,}36\sigma$$

On voit ici une diminution notable de l'effet de la tension d'offset des comparateurs C, diminution obtenue à l'aide du deuxième étage de réseau de résistances. Les suiveurs de tension A connectés entre les deux réseaux de résistances évitent toute perte de gain. On pourrait généraliser l'invention en enchaînant d'autres réseaux de résistances, décorrellés des précédents au moyen de suiveurs de tension, en aval des deux décrits ici. Néanmoins, cet enchaînement augmente notablement le nombre de composants présents sur un substrat sur lequel est réalisé le convertisseur analogique numérique.

L'invention peut être mise en oeuvre pour une architecture de circuit de comparaison comportant des comparateurs travaillant tous en parallèle. Cette architecture est bien connue dans la littérature anglo-saxonne sous le nom de « flash ». L'invention peut également être mise en oeuvre pour une architecture de circuit de comparaison dite « en repliement » et comportant un plus petit nombre de comparateurs travaillant en parallèle. Ces comparateurs sont alors utilisés plusieurs fois sur la plage. Cette architecture est bien connue dans la littérature anglo-saxonne sous le nom de « folding ».

**Revendications**

1. Circuit de comparaison pour un convertisseur analogique-numérique comportant un réseau de comparateurs (C) comparant chacun une tension analogique (V) à convertir avec une tension de référence (Vref), les tensions de référence (Vref) étant réparties sur une plage dans laquelle la tension analogique (V) peut évoluer, chaque comparateur (C) comprenant une sortie directe (O) et une sortie inverse ($\overline{O}$), **caractérisé en ce que** chaque sortie, directe (O) ou inverse ($\overline{O}$), est raccordée à l'entrée d'un suiveur de tension (A), les sorties de chaque suiveur de tension (A) étant reliées soit à des entrées d'un premier réseau (2) de résistances (R1 à R8) délivrant à ses sorties (O'), des tensions moyennes de celles présentes sur des sorties directes (O) de comparateurs (C) recevant des tensions de référence (Vref) voisines dans leur répartition sur la plage, soit à des entrées d'un second réseau de résistances délivrant à ses sorties (O'), des tensions moyennes de celles présentes sur des sorties inverses ($\overline{O}$) de comparateurs (C) recevant des tensions de référence (Vref) voisines dans leur répartition sur la plage.

2. Circuit de comparaison selon la revendication 1, **caractérisé en ce que** les sorties (O') du premier réseau (2) de résistances sont reliées, par l'intermédiaire de suiveurs de tension (A), à des entrées d'un troisième réseau (3) de résistances (R1 à R8) délivrant à ses sorties (O"), des tensions moyennes de celles présentes sur des entrées voisines du troisième réseau (3) de résistances, et **en ce que** les sorties (O') du second réseau de résistances sont reliées, par l'intermédiaire de suiveurs de tension (A), à des entrées d'un quatrième réseau de résistances délivrant à ses sorties (O"), des tensions moyennes de celles présentes sur des entrées voisines du quatrième réseau de résistances.

3. Circuit de comparaison selon l'une des revendications précédentes, **caractérisé en ce que** les réseaux (2, 3) de résistances ont la même structure.

4. Circuit de comparaison selon la revendication 3, **caractérisé en ce que** chaque réseau de résistances comporte un premier ensemble en série de deux paires identiques de deux résistances identiques en série, (R1, R2) d'une part, (R3, R4) d'autre part, et un deuxième ensemble en série de deux paires identiques de deux résistances identiques en série (R5, R6) d'une part, (R7, R8) d'autre part et **en ce que** les entrées du réseau de résistances sont constituées par les extrémités et le point milieu du premier ensemble en série, et les sorties du réseau de résistances sont constituées par les extrémités et le point milieu du deuxième ensemble en série, le point milieu de la première paire et de la deuxième paire de résistances du premier ensemble sont reliés respectivement au point milieu de la première paire et de la deuxième paire du deuxième ensemble.

**Claims**

1. A comparison circuit for an analogue-digital converter comprising an array of comparators (C) each comparing an analogue voltage (V), which is to be converted, with a reference voltage (Vref), the reference voltages (Vref) being distributed over a range in which the analogue voltage (V) may vary, each comparator (C) comprising a direct output (O) and an inverse output (0) **characterised in that** each output, direct (O) or inverse $\overline{(O)}$ is connected to the input of a voltage follower (A), the outputs of each voltage follower (A) either being connected to the inputs of a first array (2) of resistors (R1 to R8) feeding to the outputs (O') thereof, the average values of the voltages present over the direct outputs (O) of comparators (C) receiving reference voltages (Vref) which are adjacent in relation to their distribution over the range, or to the inputs of a second array of resistors feeding to the outputs $\overline{(O'')}$ thereof, the average values of the voltages present over the inverse outputs $\overline{(O)}$ of comparators (C) receiving reference voltages (Vref) which are adjacent in relation to their distribution over the range.

2. The comparison circuit according to claim 1, **characterised in that** the outputs (O') of the first array (2) of resistors are connected, via voltage followers (A), to the inputs of a third array (3) of resistors (R1 to R8) feeding to the outputs (0") thereof the average values of the voltages present over the adjacent inputs of the third array (3) of resistors, and **in that** the outputs $\overline{(O',)}$ of the second array of resistors are connected, by means of voltage followers (A), to the inputs of a fourth array of resistors feeding to the outputs $(\overline{O}''')$ thereof the average values of the voltages present over the adjacent inputs of the fourth array of resistors.

3. The comparison circuit according to any one of the preceding claims, **characterised in that** the arrays (2, 3) of resistors have the same structure.

4. The comparison circuit according to claim 3, **characterised in that** each array of resistors comprises a first set in series of two identical pairs of two identical resistors connected in series, (R1, R2) on the one hand and (R3, R4) on the other hand, and a second set in series of two identical pairs of two identical resistors connected in series, (R5, R6) on the one hand and (R7, R8) on the other hand, and **in that** the inputs of the array of resistors are constituted by the ends and the centre point of the first set connected in series, and the outputs of the array of resistors are constituted by the ends and the centre point of the second set connected in series, the centre point of the first pair and the second pair of resistors of the first set are respectively connected to the centre point of the first pair and the second pair of the second set.

**Patentansprüche**

1. Vergleichsschaltung für einen Analog-Digital-Wandler, umfassend eine Anordnung von Komparatoren (C), die jeweils eine umzuwandelnde Analogspannung (V) mit einer Referenzspannung (Vref) vergleichen, wobei die Referenzspannungen (Vref) über einen Bereich verteilt sind, über den die Analogspannung (V) variieren kann, wobei jeder Komparator (C) einen direkten Ausgang (O) und einen umgekehrten Ausgang $(\overline{O})$ umfasst, **dadurch gekennzeichnet, dass** jeder Ausgang, direkt (O) oder umgekehrt $(\overline{O})$, mit dem Eingang eines Spannungsfolgers (A) verbunden ist, wobei die Ausgänge jedes Spannungsfolgers (A) entweder mit den Eingängen einer ersten Anordnung (2) von Widerständen (R1 bis R8) verbunden sind, die an ihre Ausgänge (O') die Durchschnittswerte der Spannungen anlegen, die an den direkten Ausgängen (O) von Komparatoren (C) anliegen, die Referenzspannungen (Vref) empfangen, die im Hinblick auf ihre Verteilung über den Bereich benachbart sind, oder mit den Eingängen einer zweiten Anordnung von Widerständen, die an ihre Ausgänge $(\overline{O}'')$ die Durchschnittswerte der Spannungen anlegen, die an den umgekehrten Ausgängen $(\overline{O})$ von Komparatoren (C) anliegen, die Referenzspannungen (Vref) empfangen, die im Hinblick auf ihre Verteilung über den Bereich benachbart sind.

2. Vergleichsschaltung nach Anspruch 1, **dadurch gekennzeichnet, dass** die Ausgänge (O') der ersten Anordnung (2) von Widerständen über Spannungsfolger (A) mit den Eingängen einer dritten Anordnung (3) von Widerständen (R1 bis R8) verbunden sind, die an ihre Ausgänge (0") die Durchschnittswerte der Spannungen anlegen, die an den benachbarten Eingängen der dritten Anordnung (3) von Widerständen anliegen, und **dadurch**, dass die Ausgänge $(\overline{O}'')$ der zweiten Anordnung von Widerständen über Spannungsfolger (A) mit den Eingängen einer vierten Anordnung von Widerständen verbunden sind, die an ihre Ausgänge $(\overline{O}''')$ die Durchschnittswerte von Spannungen anlegen, die an den benachbarten Eingängen der vierten Anordnung von Widerständen anliegen.

3. Vergleichsschaltung nach einem der vorherigen Ansprüche, **dadurch gekennzeichnet, dass** die Anordnungen (2, 3) von Widerständen dieselbe Struktur haben.

4. Vergleichsschaltung nach Anspruch 3, **dadurch gekennzeichnet, dass** jede Anordnung von Widerständen einen ersten seriellen Satz von zwei identischen Paaren von zwei identischen Widerständen in Serie (R1, R2) einerseits und (R3, R4) andererseits und einen zweiten seriellen Satz von zwei identischen Paaren von zwei identischen Widerständen in Serie (R5, R6) einerseits und (R7, R8) andererseits umfasst, und **dadurch**, dass die Eingänge der Anordnung von Widerständen von den Enden und vom Mittelpunkt des ersten seriellen Satzes und die Ausgänge der Anordnung von Widerständen durch die Enden und den Mittelpunkt des zweiten Satzes in Serie gebildet werden, wobei der Mittelpunkt des ersten Paares und des zweiten Paares von Widerständen des ersten Satzes jeweils mit dem Mittelpunkt des ersten Paares und des zweiten Paares des zweiten Satzes verbunden sind.

Fig. 1

Fig. 2